(19) Europäisches Patentamt
European Patent Office
Office européen des brevets

(11) **EP 1 336 249 B1**

(12) **EUROPÄISCHE PATENTSCHRIFT**

(45) Veröffentlichungstag und Bekanntmachung des
Hinweises auf die Patenterteilung:
**17.08.2005   Patentblatt 2005/33**

(21) Anmeldenummer: **01983595.8**

(22) Anmeldetag: **21.11.2001**

(51) Int Cl.⁷: **H03L 7/085**, H03L 7/081

(86) Internationale Anmeldenummer:
**PCT/EP2001/013517**

(87) Internationale Veröffentlichungsnummer:
**WO 2002/043246 (30.05.2002 Gazette 2002/22)**

(54) **PHASENREGELKREIS MIT VERZÖGERUNGSELEMENT**

DELAY-LOCKED LOOP CIRCUIT

CIRCUIT BOUCLE A RETARD VERROUILLE

(84) Benannte Vertragsstaaten:
**DE FR GB IT NL**

(30) Priorität: **21.11.2000  DE 10057905**

(43) Veröffentlichungstag der Anmeldung:
**20.08.2003   Patentblatt 2003/34**

(73) Patentinhaber: **Micronas GmbH**
**79108 Freiburg (DE)**

(72) Erfinder: **BIDENBACH, Reiner**
**79279 Vörstetten (DE)**

(74) Vertreter: **Göhring, Robert, Dipl.-Ing. et al**
**Patentanwälte**
**Westphal, Mussgnug**
**Am Riettor 5**
**78048 Villingen-Schwenningen (DE)**

(56) Entgegenhaltungen:
**EP-A- 0 138 276**          **EP-A- 0 353 807**
**EP-A- 0 441 684**          **US-A- 6 037 812**

**Beschreibung**

Die Erfindung betrifft einen Phasenregelkreis mit Phasendetektor, Schleifenfilter und Verzögerungselement nach dem Oberbegriff von Anspruch 1.

Im Gegensatz zu Phasenregelkreisen mit selbstschwingendem Oszillator (PLL - phase locked loop) ergibt sich bei einem Phasenregelkreis mit einem Verzögerungselement (DLL - delayed locked loop) das Problem, dass die verzögerten Ausgangssignale des Verzögerungselementes für alle Verzögerungen, die einem ganzzahligen Vielfachen des Taktes des Eingangssignals entsprechen, nicht unterscheidbar sind. Es besteht somit die Gefahr, dass sich die Verzögerungszeit als ein unbestimmtes ganzzahliges Vielfaches der Periodendauer des Eingangssignals einregelt.

Um dies zu vermeiden, ist es einerseits bekannt, die mögliche Verzögerungszeit des Verzögerungselementes zu begrenzen. Diese Maßnahme hat jedoch den Nachteil, dass der Frequenzbereich stark eingeschränkt wird. Insbesondere bei integrierten Schaltkreisen kommt dabei dann noch das Problem hinzu, dass eine absolute Genauigkeit des Begrenzers gefordert wird. Sofern das Verhältnis zwischen dem Signal und der Pause des Taktes des Eingangssignals von 50 % abweicht, ist zusätzlich eine Begrenzung der Verzögerungszeit nach unten erforderlich, was den Frequenzbereich noch weiter einschränkt.

Andererseits ist es bekannt, die Einregelung der Verzögerungszeit als ein unbestimmtes ganzzahliges Vielfaches der Periodendauer des Eingangssignals dadurch zu vermeiden, dass eine Zuordnung beziehungsweise Detektion der Zugehörigkeit von Flanken des Ausgangssignals zu Flanken des Eingangssignals vorgenommen wird. Dies ist jedoch sehr aufwendig und insbesondere bei hohen Signalfrequenzen mit vernünftigem Aufwand kaum realisierbar.

Der Erfindung liegt deshalb die Aufgabe zugrunde, einen Phasenregelkreis mit Phasendetektor, Schleifenfilter und Verzögerungselement zu schaffen, bei dem diese Probleme nicht mehr auftreten und bei dem unzulässige Verzögerungszeiten erkannt und durch entsprechende Korrekturen beseitigt werden können.

Gelöst wird diese Aufgabe bei einem Phasenregelkreis der eingangs genannten Art gemäß Anspruch 1 dadurch, dass das Verzögerungselement eine Kette einer Anzahl n von Verzögerungsgliedern aufweist, deren Ausgänge einer Einrast-Überwachungsschaltung zugeführt werden, mit der festgestellt wird, ob die Verzögerungszeit $T_{Verzögerung}$ des Verzögerungselementes relativ zu einer Periode $T_{Periode}$ eines Eingangssignals an dem Phasendetektor in einem Bereich von $a * T_{Periode} < T_{Verzögerung} < b * T_{Periode}$ liegt, wobei $0,5 < a < 1$ und $1 < b < 2$ ist und wobei mit der Einrast-Überwachungsschaltung eine Korrektur der Verzögerungszeit vorgenommen wird, wenn diese Bedingung nicht erfüllt ist.

Die Unteransprüche haben vorteilhafte Weiterbildungen der Erfindung zum Inhalt.

Weitere Einzelheiten, Merkmale und Vorteile der Erfindung ergeben sich aus der folgenden Beschreibung einer bevorzugten Ausführungsform anhand der Zeichnung. Es zeigt:

Fig. 1 ein Prinzipschaltbild einer solchen Ausführungsform;
Fig. 2 ein Prinzipschaltbild eines Verzögerungselementes; und
Fig. 3 ein Prinzipschaltbild einer Einrast-Überwachungsschaltung.

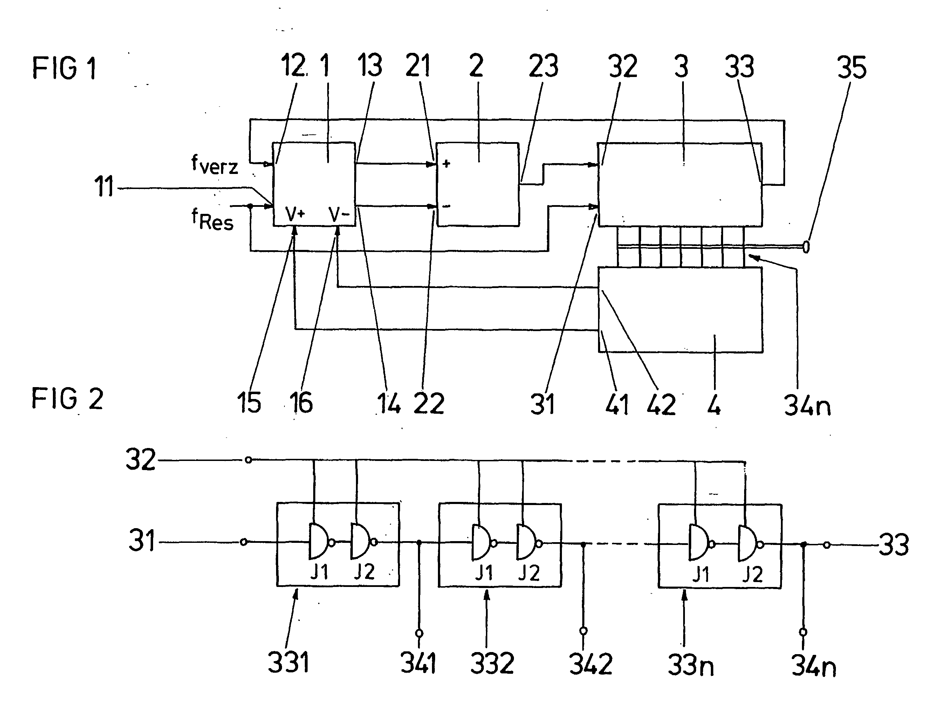

Die in Figur 1 gezeigte Schaltung umfasst einen Phasendetektor 1, einen Schleifenfilter 2, ein Verzögerungselement 3 mit einer Kette von n Verzögerungsgliedern, sowie eine Einrast-Überwachungsschaltung 4.

Ein Eingangssignal mit einer Referenzfrequenz $f_{Ref}$ liegt an einem ersten Eingang 11 des Phasendetektors 1 sowie einem ersten Eingang 31 des Verzögerungselementes 3 an. Der Phasendetektor weist einen zweiten Eingang 12 für ein Rückkopplungssignal des Verzögerungselementes 3 mit einer Frequenz $f_{Verz}$ auf, das über einen Ausgang 33 des Verzögerungselementes 3 zugeführt wird. Die in dem Verzögerungselement enthaltenen n Verzögerungsglieder sind über jeweils eine der Verbindungsleitungen 34n (n = 1, 2, 3,...) mit der Einrast-Überwachungsschaltung 4 sowie einem Schaltungsausgang 35 verbunden.

Das Schleifenfilter 2 weist einen ersten positiven Eingang 21 sowie einen zweiten negativen Eingang 22 auf. An dem ersten Eingang 21 liegt ein erster Ausgang 13 des Phasendetektors 1 an, während der zweite Eingang 22 des Schleifenfilters 2 ist mit einem zweiten Ausgang 14 des Phasendetektors 1 verbunden ist. Der Ausgang 23 des Schleifenfilters 2 ist mit einem zweiten Eingang 32 des Verzögerungselementes 3 für eine Steuerspanung verbunden.

Schließlich ist ein erster Ausgang 41 der Einrast-Überwachungsschaltung 4 mit einem positiven (V+) Eingang 15 und ein zweiter Ausgang 42 der Einrast-Überwachungsschaltung 4 mit einem negativen (V-) Eingang 16 des Phasendetektors 1 verbunden.

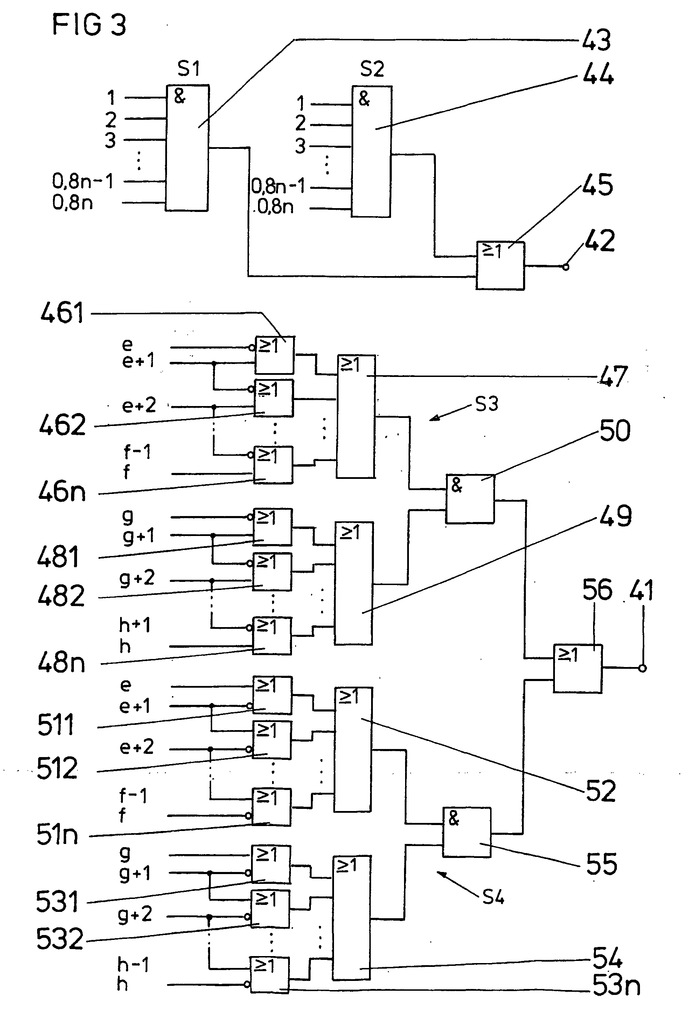

Figur 2 zeigt ein Prinzipschaltbild eines beispielhaften Verzögerungselementes 3. Es setzt sich aus einer Reihenschaltung einer Anzahl n von Verzögerungsgliedern 33n (n = 1, 2,...) zusammen, die jeweils durch zwei in Reihe geschaltete Inverter I1, I2 gebildet sind. Der Eingang des ersten Verzögerungsgliedes 331 ist mit dem ersten Eingang 31 des Verzögerungselementes 3 verbunden, während der Ausgang des letzten Verzögerungsgliedes 33n an dem Ausgang 33 des Verzögerungselementes 3 anliegt. Der Ausgang jedes Verzögerungselementes 33n ist mit jeweils einer der Verbindungsleitungen 34n zu der Einrast-Überwachungsschaltung 4 verbunden. Schließlich werden die Inverter I1, I2 der Verzögerungsglieder 33n über eine gemeinsame, mit dem zweiten Eingang 32 des Verzögerungselementes 3 verbundenen Steuerleitung ansteuert.

Figur 3 zeigt beispielhaft ein Prinzipschaltbild einer Einrast-Überwachungsschaltung 4. Die Schaltung umfasst im wesentlichen vier Stufen S1 bis S4. Mit der ersten Stufe S1 zur Auswertung von "high"-Zuständen der Verzögerungsglieder 33n erfolgt eine UND-Verknüpfung der über die Verbindungsleitungen 34n (n = 1, 2, 3,...) zugeführten Signale mit einem ersten UND-Glied 43, wobei Faktor (von zum Beispiel 0,8) * n Signale verwendet werden. Mit der zweiten Stufe S2 zur Auswertung von "low"-Zuständen der Verzögerungsglieder 33n werden diese (Faktor multipliziert mit n) zugeführten Signale invertiert und anschließend mit einem zweiten UND-Glied 44 UND-verknüpft. Die Ausgänge der beiden UND-Glieder 43, 44 werden mit einem ODER-Glied 45 verknüpft, dessen Ausgang mit dem negativen zweiten Ausgang 42 der Einrast-Überwachungsschaltung 4 verbunden ist.

Die dritte Stufe S3 dient zur Auswertung von fallenden Flanken an den Ausgängen der Verzögerungsglieder 33n und umfasst eine Anzahl n von ersten UND-Gliedern 46n, deren Ausgänge jeweils einem zweiten ODER-Glied 47 zugeführt sind. Die dritte Stufe S3 umfasst weiterhin eine Anzahl n von dritten UND-Gliedern 48n (n = 1, 2, 3,...), deren Ausgänge jeweils einem vierten ODER-Glied 49 zugeführt sind. Die Ausgänge des zweiten und vierten ODER-Gliedes 47 und 49 werden schließlich mit einem UND-Glied 50 verknüpft. An den beiden Eingängen der ersten und dritten UND-Glieder 46n, 48n liegen jeweils zwei aufeinanderfolgende Ausgänge e, e+1,...; g, g+1,... von bestimmten Verzögerungsgliedern 33n des Verzögerungselementes 3 an, wobei jeweils ein erster Eingang invertiert und ein zweiter Eingang nichtinvertiert ist. Die Auswahl der Ausgänge wird weiter unten noch beschrieben werden.

Die vierte Stufe S4 dient zur Auswertung von steigenden Flanken an den Ausgängen der Verzögerungsglieder 33n und ist mit gleichen Elementen 51n, 52, 53n, 54, 55 (n = 1, 2, 3,...) und in gleicher Weise aufgebaut, wie die dritte Stufe S3. Dies betrifft auch die an den Eingängen der ersten und dritten UND-Glieder 51n, 53n anliegenden Signale. Der einzige Unterschied besteht darin, dass die ersten Eingänge der ersten und dritten UND-Glieder 51n, 53n nichtinvertierend und die zweiten Eingänge dieser Glieder invertierend sind. Die Ausgänge der UND-Glieder 50 und 55 der dritten bzw. vierten Stufe werden schließlich einem fünften ODER-Glied 56 zugeführt, dessen Ausgang mit dem positiven ersten Ausgang 41 der Einrast-Überwachungsschaltung 4 verbunden ist.

Im folgenden sollen nun die Funktionen und die prinzipielle Arbeitsweise des Phasenregelkreises beschrieben werden.

Dadurch, dass das Verzögerungselement 3 durch eine Kette aus n Verzögerungsgliedern 33n gebildet ist, kann der Zustand der Ausgänge dieser Verzögerungsglieder an den Verbindungsleitungen 34n dazu verwendet werden, unzulässige Verzögerungszeiten zu erfassen und entsprechende Korrekturen mit der Einrast-Überwachungsschaltung 4 vorzunehmen.

Zu diesem Zweck stellt die Einrast-Überwachungsschaltung 4 fest, ob die Verzögerungszeit $T_{Verzögerung}$ des Verzögerungselementes 3 relativ zu der Periode $T_{Periode}$ des Eingangssignals in einem Bereich von $a * T_{Periode} < T_{Verzögerung} < b * T_{Periode}$ liegt, wobei $0,5 < a < 1$ und $1 < b < 2$ ist. Die genauen Werte von a und b hängen dabei im wesentlichen von der Implementierung der Einrast-Überwachungsschaltung 4 ab, die wiederum im wesentlichen durch die Eigenschaften des Phasendetektors 1 bestimmt wird.

Besteht das Verzögerungselement 3 aus n Verzögerungsgliedern 33n, so kann eine maximale Verzögerungszeit von $n * T_{Periode}$ von der Einrast-Überwachungsschaltung 4 erkannt werden. In der Praxis stellt dies keine Einschränkung dar, da $T_{Verzögerungsglied} < T_{Periode}$ für fast alle Arten von Verzögerungsgliedern gilt.

Die Feststellung, ob $T_{Verzögerung} < a * T_{Periode}$ ist, kann anhand der Anzahl gleicher aufeinanderfolgender Zustände in der Kette von n Verzögerungsgliedern 33n getroffen werden.

Bei einem Takt / Pausenverhältnis von 50% des Eingangssignals sind dies $0,5 * n$ Verzögerungsglieder für $a = 1$ und $1 * n$ Verzögerungsglieder für $a = 0,5$. Dies bedeutet, dass die Einrast-Überwachungsschaltung 4 bei einer Anzahl m von aufeinanderfolgenden Verzögerungsgliedern gleichen Zustands, wobei $0,5 * n < m < n$ gilt, dem Phasendetektor 1 das vorrangige Signal "-" geben muss. Dies bedeutet, dass das Signal der Einrast-Überwachungsschaltung 4 Vorrang vor dem Signal des Phasendetektors 1 hat. Somit wird die Verzögerungszeit erhöht, bis die oben genannte Bedingung nicht mehr erfüllt ist und der Phasendetektor 1 die Feineinstellung der Verzögerungszeit selbst übernimmt.

Bei einem Takt / Pausenverhältnis ungleich 50% müssen beide Zustände ("low" und "high") des Eingangssignals überwacht werden und die Ergebnisse "ODER" verknüpft werden. Dies bedeutet, dass jedes der beiden Ergebnisse für "low"- bzw. "high"-Zustände zu einem Signal an dem ersten Ausgang 41 der Einrast-Überwachungsschaltung 4 führen kann. Bei einem Takt / Pausenverhältnis ungleich 50% wird der Einstellbereich des Phasendetektors 1 eingeschränkt. Dies beruht darauf, dass der Phasendetektor 1 seine Entscheidung nicht allein aufgrund einer zum Beispiel steigenden Signalflanke treffen kann, wie es bei PLL-Schaltungen allgemein üblich ist. Vielmehr ist eine zusätzliche Zeitinformation zwischen zwei gleichartigen Flanken erforderlich, die das Ende des für die Auswertung gültigen Zeitbereiches angibt. Im Idealfall liegt diese Zeitinformation genau in der Mitte zwischen zwei gleichartigen Flanken. Eine solche Zeitinformation läßt sich jedoch nur unter großem Aufwand gewinnen. Man verwendet deshalb vorzugsweise einen anderen Flankentyp, zum Beispiel eine fallende Flanke. Wenn in diesen Fall das Takt / Pausenverhältnis ungleich 50 Prozent ist, wird der zur Flankenauswertung gültige Zeitbereich eingeschränkt. Dies beruht darauf, dass die Flanke des anderen Typs dann nicht genau in der Periodenmitte liegt.

Weiterhin muss der Wert von a dann so gewählt werden, dass $a > T_{high} / T_{Periode}$ UND $a > T_{low} / T_{Periode}$ gilt.

Die Werte von a und b sind im Prinzip variabel und werden durch die Implementierung der Schaltung, das heißt die Anzahl n der Verzögerungsglieder 33n, die Anzahl der aufeinanderfolgend überwachten Glieder und den Fangbereich des Phasendetektors 1 bestimmt. Sofern wie in dem zuvor beschriebenen Fall der Fangbereich des Phasendetektors 1 auch von dem Takt / Pausenverhältnis abhängig ist, werden die Werte von a und / oder b auch durch dieses Verhältnis bestimmt.

Die Feststellung, ob $T_{Verzögerung} > b * T_{Periode}$ ist, kann ebenfalls aufgrund der Anzahl von gleichen aufeinanderfolgenden Zuständen in der Kette der n Verzögerungsglieder 33n getroffen werden. Für die Grenze b = 2 müssen n / 4 aufeinanderfolgende Verzögerungsglieder den gleichen Zustand haben, für b = 1 sind es n / 2. Haben also p aufeinanderfolgende Verzögerungsglieder zu keiner Zeit gleichzeitig den gleichen Zustand, wobei n / 4 < p < n / 2 gilt, so gibt die Einrast-Überwachungsschaltung 4 über den ersten Ausgang 41 dem Phasendetektor 1 ein vorrangiges "+"-Signal (d.h. dass das Signal der Einrast-Überwachungsschaltung 4 Vorrang vor dem Signal des Phasendetektors 1 hat), um die Verzögerungszeit zu verkleinern.

Bei einem Takt / Pausenverhältnis ungleich 50% müssen wie bei der Überwachung von $T_{Verzögerung} < a * T_{Periode}$ beide Zustände, nämlich "low" und "high" überwacht werden, wobei die Ergebnisse beider Prüfungen wieder "ODER" verknüpft werden müssen.

Im einzelnen läuft diese Entscheidung somit vierstufig ab. In der ersten und zweiten Stufe S1 und S2 wird auf das Vorliegen der Bedingung $T_{Verzögerung} < a * T_{Periode}$ geprüft. Wird diese Bedingung in mindestens einer dieser beiden Stufen erkannt, so wird das vor dem Signal des Phasendetektors 1 vorrangige Signal "-" am zweiten Ausgang 42 der Einrast-Überwachungsschaltung 4 gesetzt. In den Stufen S3 und S4 der Entscheidung wird auf das Vorliegen der Bedingung $T_{Verzö-gerung} > b * T_{Periode}$ geprüft. Wenn diese Bedingung in mindestens einer der Stufen S3 und S4 erkannt wird, so wird das vor dem Signal des Phasendetektors 1 vorrangige Signal "+" am ersten Ausgang 41 der Einrast-Überwachungsschaltung 4 gesetzt. Diese vierstufige Prüfung ist nur dann erforderlich, wenn das Takt / Pausenverhältnis ungleich 50 Prozent ist. Wenn dagegen dieses Verhältnis 50 Prozent beträgt, so ist eine zweistufige Entscheidung ausreichend, da die Ergebnisse der ersten und zweiten Stufe S1, S2 einerseits mit den Ergebnissen der dritten und vierten Stufe S3, S4 andererseits identisch sind.

Ein Nachteil dieses Verfahrens besteht darin, dass mit zunehmender Taktunsymmetrie des Eingangssignals der Wert von b immer größer gewählt werden muss. Im Grenzfall von 25% bzw. 75% Takt / Pausenverhältnis ist b = 2, bei noch größerer Unsymmetrie scheidet dieses Verfahren ganz aus.

Die Feststellung, ob $T_{Verzögerung} > b * T_{Periode}$ ist, wird daher bevorzugt auf eine andere Art bestimmt. Statt aufeinanderfolgende Zustände auszuwerten, werden Signalübergänge (Flanken) in der Kette aus n Verzögerungsgliedern 33n detektiert. Bei der Auswertung kann man sich auf eine Art von Flanken, d. h. steigend oder fallend, beschränken. Sinnvollerweise nimmt man die Art von Flanken, die auch von dem Phasendetektor 1 als zeitkritische Flanken verwendet werden. Man detektiert nun, ob in zwei unterschiedlichen Bereichen in der Kette von n Verzögerungsgliedern 33n die gleiche Art von Flanken auftritt. Für b = 1 reicht der Anfang von Bereich 1 (e) bis zum Ende des Bereichs 2 (h) über alle n Verzögerungsglieder. Für b = 2 reicht der Anfang von Bereich 1 (e) bis zum Ende des Bereichs 2 (h) über n / 2 Verzögerungsglieder. Für die Länge der beiden Bereiche muss gelten, dass sie mehr als ein Viertel des Abstandes vom Anfang des Bereiches 1 (e) bis zum Ende des Bereiches 2 (h) beträgt: (f - e) > (h - e) / 4 UND (h - g) > (h - e) / 4.

Hierbei bezeichnen (e) die Nummer des Verzögerungsgliedes am Anfang des Bereiches 1, (f) die Nummer des Verzögerungsgliedes am Ende des Bereiches 1, (g) die Nummer des Verzögerungsgliedes am Anfang des Bereiches 2 und (h) die Nummer des Verzögerungsgliedes am Ende des Bereiches 2. Die Numerierung erfolgt dabei beginnend mit der Nummer 1 am Anfang der Verzögerungskette fortlaufend bis zur Nummer n an deren Ende.

Tritt nun eine Art von Flanken in beiden so definierten Bereichen des Verzögerungselementes 3 gleichzeitig auf, so signalisiert die Einrast-Überwachungsschaltung 4 dem Phasendetektor 1 ein vorrangiges "+"-Signal über den ersten Ausgang 41 (d.h. dass das Signal der Einrast-Überwachungsschaltung 4 Vorrang vor dem Signal des Phasendetektors 1 hat), um die Verzögerungszeit $T_{Verzögerung}$ zu verkleinern.

Als Phasendetektor 1 kommt im wesentlichen nur ein Typ in Frage, der maximal einen Bereich kleiner 360 Grad überdeckt. Sequentielle Phasendetektoren mit einem Überdekkungsbereich von 720 Grad oder mehr, wie sie oft in PLLs verwendet werden, sind weniger geeignet.

Ideal wäre ein Phasendetektor 1 mit einem Überdeckungsbereich von -180 + e Grad bis +180 - e Grad, wobei e > 0 und e -> 0 gilt. Ein solcher Phasendetektor ist für das vorgestellte erfindungsgemäße Prinzip bei jedem Takt / Pausenverhältnis besonders geeignet. Eine technische Schwierigkeit besteht jedoch darin, eine Information über die Hälfte der Taktperiode $T_{Periode}$ / 2 zu erlangen, da gemäß obiger Erläuterungen eine zusätzliche Zeitinformation erforderlich ist.

Man setzt deshalb vorzugsweise einen Phasendetektor ein, dessen Überdeckungsbereich von beiden Flankenarten gesteuert wird. Bei unsymmetrischem Takt / Pausenverhältnis wird auch der Überdeckungsbereich eines solchen Phasendetektors unsymmetrisch, er beträgt dann $-360° * (1 - [T_{high} / T_{Periode}])$ < Überdeckungsbereich < $360° * [T_{high} / T_{Periode}]$ oder $-360° * (1 - [T_{low} / T_{Periode}])$ < Überdeckungsbereich < $360° * [T_{low} / T_{Periode}]$, je nachdem, welche Flankenart zum Setzen bzw. Rücksetzen der "+" / "-" Signale verwendet wird.

Man muss beachten, dass der Wert von b und damit die Größe der Detektionsbereiche (f - e) und (h - g) so gewählt werden müssen, dass die Einrast-Überwachungsschaltung 4 die Regelung über den Phasendetektor 1 nur dann freigibt, wenn die Phasenlage der Eingangssignale des Phasendetektors 1 in dessen Überdeckungsbereich liegen. Beachtet man dieses nicht, so kann die Regelung den eingerasteten Zustand nicht sauber erreichen und schwingt möglicherweise. Die Einrast-Überwachungsschaltung 4 bringt dann zwar $T_{Verzögerung}$ näher an $T_{Periode}$ heran, nicht jedoch nahe genug für den Phasendetektor 1. Es ist dann zwar möglich, dass $T_{Verzögerung}$ in den Fangbereich des Phasendetektors gelangt und die Regelung einrasten kann. Es ist jedoch auch möglich, dass $T_{Verzögerung}$ wieder vom Fangbereich wegdriftet. In diesem Fall schwingt die Regelung und kann nicht einrasten.

Wählt man z. B. (h - e) = 0.8 * n, so ergibt sich eine maximale Phasenlage von 90° am Phasendetektor 1. Das minimal bzw. maximal erlaubte Takt / Pausenverhältnis liegt in diesem Fall bei 25% bzw. 75%, und zwar je nach Art der Flanken, die in dem Phasendetektor 1 ausgewertet werden.

Der erfindungsgemäße Phasenregelkreis ist vorzugsweise zur Generierung verschobener Takte in Multiclocksystemen oder Taktverjitterern, Taktvervielfacher, Taktsymmetrisierer zur Gewinnung von 50% Takt / Pausenverhältnissen aus beliebig unsymmetrischen Takten geeignet.

**Patentansprüche**

1. Phasenregelkreis mit Phasendetektor, Schleifenfilter und Verzögerungselement, **dadurch gekennzeichnet, dass** das Verzögerungselement (3) eine Kette einer Anzahl n von Verzögerungsgliedern (33n) aufweist, deren Ausgänge (34n) einer Einrast-Überwachungsschaltung (4) zugeführt werden, mit der festgestellt wird, ob die Verzögerungszeit $T_{Verzöge-rung}$ des Verzögerungselementes (3) relativ zu einer Periode $T_{Periode}$ eines Eingangssignals an dem Phasendetektor (1) in einem Bereich von $a * T_{Periode} < T_{Verzögerung} < b * T_{Periode}$ liegt, wobei $0{,}5 < a < 1$ und $1 < b < 2$ ist und wobei mit der Einrast-Überwachungsschaltung (4) eine Korrektur der Verzögerungszeit vorgenommen wird, wenn diese Bedingung nicht erfüllt ist.

2. Phasenregelkreis nach Anspruch 1, **dadurch gekennzeichnet, dass** die Bedingung, ob $T_{Verzögerung} < a * T_{Periode}$ ist, anhand einer Anzahl m von aufeinanderfolgenden Verzögerungsgliedern (33n) mit gleichem Zustand geprüft wird.

3. Phasenregelkreis nach Anspruch 2, **dadurch gekennzeichnet, dass** bei einem Takt / Pausenverhältnis des Eingangssignals von etwa 50 Prozent die Einrast-Überwachungsschaltung (4) eine Korrektur durch Erhöhung der Verzögerungszeit durch Beaufschlagung des Phasendetektors (1) vornimmt, wenn die Bedingung $0{,}5 * n < m < n$ gilt.

4. Phasenregelkreis nach Anspruch 2, **dadurch gekennzeichnet, dass** bei einem Takt / Pausenverhältnis des Eingangssignals von ungleich 50 Prozent die "low"- und "high"-Zustände der Verzögerungsglieder (33n) überwacht und die Ergebnisse ODER-verknüpft werden, wobei a so gewählt wird, dass die Bedingung $a > T_{high} / T_{Periode}$ UND $a > T_{low} / T_{Periode}$ gilt.

5. Phasenregelkreis nach Anspruch 1, **dadurch gekennzeichnet, dass** die Bedingung, ob $T_{Verzögerung} > b * T_{Periode}$ ist, anhand einer Anzahl p von aufeinanderfolgenden Verzögerungsgliedern (33n) geprüft wird, die zu keiner Zeit den gleichen Zustand aufweisen.

6. Phasenregelkreis nach Anspruch 5, **dadurch gekennzeichnet, dass** bei einem Takt / Pausenverhältnis des Eingangssignals von etwa 50 Prozent die Einrast-Überwachungsschaltung (4) eine Korrektur durch Verminderung der Verzögerungszeit durch Beaufschlagung des, Phasendetektors (1) vornimmt, wenn die Bedingung $n/4 < p < n/2$ gilt.

7. Phasenregelkreis nach Anspruch 5, **dadurch gekennzeichnet, dass** bei einem Takt / Pausenverhältnis des Eingangssignals von ungleich 50 Prozent die "low"- und "high"-Zustände der Verzögerungsglieder (33n) überwacht und die Ergebnisse ODER-verknüpft werden.

8. Phasenregelkreis nach Anspruch 1, **dadurch gekennzeichnet, dass** die Bedingung, ob $T_{Verzögerung} > b * T_{Periode}$ ist, anhand der gleichen Art von steigenden und / oder fallenden Signalübergängen (Flanken) in mindestens zwei unterschiedlichen Bereichen der Kette aus n Verzögerungsgliedern (33n) ermittelt wird und bei gleichzeitigem Auftreten einer Art von Signalübergängen in beiden Bereichen die Einrast-Überwachungsschaltung (4) eine Korrektur durch Verminderung der Verzögerungszeit durch Beaufschlagung des Phasendetektors (1) vornimmt.

9. Phasenregelkreis nach Anspruch 8,
**dadurch gekennzeichnet, dass**
sich für einen Wert von b = 1 der Anfang eines ersten Bereiches bis zum Ende eines zweiten Bereiches 2 über alle n Verzögerungsglieder erstreckt, während für einen Wert von b = 2 der Anfang des ersten Bereiches bis zum Ende des zweiten Bereiches über n/2 Verzögerungsglieder reicht.

10. Phasenregelkreis nach Anspruch 9,
**dadurch gekennzeichnet, dass**
die Länge der beiden Bereiche so bemessen ist, dass sie mehr als ein Viertel des Abstandes vom Anfang des ersten Bereiches bis zum Ende des zweiten Bereiches gemäss folgender Bedingung beträgt: $(f - e) > (h - e) / 4$ UND $(h - g) > (h - e) / 4$, wobei e und f die Nummer des Verzögerungsgliedes am Anfang bzw. am Ende des ersten Bereiches und g und h die Nummer des Verzögerungsgliedes am Anfang bzw. am Ende des zweiten Bereiches bezeichnet und die Numerierung der Verzögerungsglieder fortlaufend von Nummer 1 am Anfang des Verzögerungselementes (3) bis zu Nummer n an dessen Ende erfolgt.

## Claims

1. A phase locked loop with phase detector, loop filter and delay circuit,
**characterised in that** the delay circuit (3) comprises a chain of a number n of delay elements (33n), the outputs (34n) of which are supplied to a latching control circuit (4), with which it is established whether the delay time $T_{delay}$ of the delay circuit (3) relative to a period $T_{period}$ of an input signal at the phase detector (1) lies in a range of $a * T_{period} < T_{delay} < b * T_{period}$, where 0.5 is $< a < 1$ and 1 is $< b < 2$ and where a correction of the delay time is performed with the latching control circuit (4) if this condition is not met.

2. A phase locked loop according to Claim 1,
**characterised in that** the condition whether $T_{delay}$ is $< a * T_{Period}$ is checked by means of a number m of successive delay elements (33n) with the same state.

3. A phase locked loop according to Claim 2,
**characterised in that** with a clock pulse/space ratio of the input signal of roughly 50 percent the latching control circuit (4) performs a correction by increasing the delay time by charging the phase detector (1) when the condition $0.5 * n < m < n$ applies.

4. A phase locked loop according to Claim 2,
**characterised in that** with a clock pulse/space ratio of the input signal of not equal to 50 percent, the low and high states of the delay elements (33n) are monitored and the results are combined with an OR operation, where a is chosen so that the condition $a > T_{high} / T_{Period}$ AND $a > T_{low} / T_{period}$ applies.

5. A phase locked loop according to Claim 1,
**characterised in that** the condition whether $T_{delay}$ is $> b * T_{period}$ is checked by means of a number p of consecutive delay elements (33n), which at no time have the same state.

6. A phase locked loop according to Claim 5,
**characterised in that** with a clock pulse/space ratio of the input signal of roughly 50 percent, the latching control circuit (4) performs a correction by reducing the delay time by charging the phase detector (1) when the condition $n/4 < p < n/2$ applies.

7. A phase locked loop according to Claim 5,
**characterised in that** with a clock pulse/space ratio of the input signal of not equal to 50 percent the low and high states of the delay elements (33n) are monitored and the results are combined with an OR operation.

8. A phase locked loop according to Claim 1,
**characterised in that** the condition whether $T_{delay}$ is $> b * T_{period}$ is determined by means of the same type of rising and/or falling signal transitions (edges) in at least two different areas of the chain of n delay elements (33n) and in the event of the simultaneous occurrence of one type of signal transition in both areas the latching control circuit (4) performs a correction by reducing the delay time by charging the phase detector (1).

9. A phase locked loop according to Claim 8,
**characterised in that** for a value of b = 1 the start of a first area extends to the end of a second area 2 over all n delay elements, while for a value of b = 2 the start of the first area extends to the end of the second area over n/2 delay elements.

10. A phase locked loop according to Claim 9,
**characterised in that** the length of the two areas is dimensioned so that it is more than one quarter of the distance from the beginning of the first area to the end of the second area in accordance with the following condition: $(f - e) > (h - e) / 4$ AND $(h - g) > (h - e) / 4$, where e and f denote the number of the delay element at the start and at the end of the first area and g and h denote the number of the delay element at the start and at the end of the second area and the numbering of the delay elements takes place consecutively from number 1 at the start of the delay circuit (3) to number n at its end.

## Revendications

1. Circuit de régulation de phase comportant un détecteur de phase, un filtre en boucle et un élément de retard
**caractérisé en ce que**
l'élément de retard (3) se compose d'une chaîne de n organes de retard (33n) dont les sorties (34n) sont appliquées à un circuit de surveillance d'accrochage (4) pour déterminer si la durée de retard $T_{Retard}$ de l'élément de retard (3) se situe par rapport à une période $T_{Période}$ d'un signal d'entrée du détecteur de phase (1) dans une plage,
$a * T_{Période} < T_{Retard} < b * T_{Période}$, pour laquelle, $0,5 < a < 1$ et $1 < b < 2$ et pour laquelle le circuit de surveillance d'accrochage (4) assure une correction de la durée de retard si cette condition n'est pas remplie.

2. Circuit de régulation de phase selon la revendication 1,
**caractérisé en ce que**
l'on vérifie la condition $T_{Retard} < a * T_{Période}$ à l'aide d'un nombre m d'organes de retard successifs (33n) dans le même état.

3. Circuit de régulation de phase selon la revendication 2,
**caractérisé en ce que**
pour un rapport Cadence/Pause du signal d'entrée correspondant sensiblement à 50 %, le circuit de surveillance d'accrochage (4) assure une correction en augmentant la durée de retard en sollicitant le détecteur de phase (1) si l'on a la condition $0,5 * n < m < n$.

4. Circuit de régulation de phase selon la revendication 2,
**caractérisé en ce que**
pour un rapport Cadence/Pause du signal d'entrée différent de 50 %, on surveille les états « bas » et « haut » des organes de retard (33n) et on combine selon la fonction logique OU les résultats, (a) étant choisi pour avoir la condition $a > T_{haut}/T_{Période}$ ET a $> T_{bas}/T_{Période}$.

5. Circuit de régulation de phase selon la revendication 1,
**caractérisé en ce qu'**
on vérifie la condition $T_{Retard} > b * T_{Période}$ à l'aide d'un nombre p d'organes de retard (33n) successifs qui à aucun moment n'ont le même état.

6. Circuit de régulation de phase selon la revendication 5,
**caractérisé en ce que**
pour un rapport Cadence/Pause du signal d'entrée de l'ordre de 50 %, le circuit de surveillance d'accrochage (4) corrige en diminuant la durée de retard en sollicitant le détecteur de phase (1) si l'on a la condition $n/4 < p < n/2$.

7. Circuit de régulation de phase selon la revendication 5,
**caractérisé en ce que**
pour un rapport Cadence/Pause du signal d'entrée différent de 50 %, on surveille les états « bas » et « haut » des organes de retard (33n) et on combine les résultats par une fonction logique OU.

8. Circuit de régulation de phase selon la revendication 1,
**caractérisé en ce qu'**
on vérifie si l'on a la condition $T_{Retard} > b * T_{Période}$ à l'aide de transition de signal (flancs) de même type, montants et/ou descendants dans au moins deux plages différentes de la chaîne de n organes de retard (33n) et lorsqu'un type de transition de signal se produit simultanément dans les deux plages, le circuit de surveillance d'accrochage (4) effectue une correction en diminuant la durée de retard par application du détecteur de phase (1).

9. Circuit de régulation de phase selon la revendication 8,
**caractérisé en ce que**
pour une valeur b = 1 le début d'une première plage jusqu'à la fin d'une seconde plage (2) couvre tous les n organes de retard alors que pour une valeur b = 2, le début de la première plage jusqu'à la fin de la seconde plage couvre n/2 organes de retard.

10. Circuit de régulation de phase selon la revendication 9,
**caractérisé en ce que**
la longueur des deux plages dimensionnées pour correspondre à plus d'un quart de la distance entre le début de la première plage jusqu'à la fin de la seconde plage selon la relation suivante :

$$(f-e)>(h-e)/4 \ ET \ (h-g)>(h-e)/4$$

dans laquelle e et f sont les numéros des organes de retard au début et à la fin de la première plage, et g et h sont les numéros de l'organe de retard au début ou à la fin de la seconde plage et la numérotation des organes de retard se fait de manière continue à partir du numéro 1 au début de l'organe de retard (3) jusqu'au numéro n à la fin de celui-ci.

FIG 1

FIG 2

FIG 3